Europäisches Patentamt

European Patent Office

Office européen des brevets

(19)

(11) **EP 1 166 132 B1**

(12) **EUROPEAN PATENT SPECIFICATION**

(45) Date of publication and mention
of the grant of the patent:
**26.07.2006 Bulletin 2006/30**

(21) Application number: **00972804.9**

(22) Date of filing: **18.10.2000**

(51) Int Cl.:
***G01R 15/20*** (2006.01)

(86) International application number:
**PCT/EP2000/010279**

(87) International publication number:
**WO 2001/050142 (12.07.2001 Gazette 2001/28)**

(54) **AN IMPROVED CURRENT SENSING DEVICE FOR LOW-VOLTAGE POWER CIRCUIT BREAKERS**

VERBESSERTE STROMFÜHLERANORDNUNG FÜR NIEDERSPANNUNGS-
LEISTUNGSSCHALTER

DETECTEUR DE COURANT AMELIORE DESTINE A DES DISJONCTEURS DE PUISSANCE BASSE
TENSION

(84) Designated Contracting States:
**AT BE CH CY DE DK ES FI FR GB GR IE IT LI LU
MC NL PT SE**

(30) Priority: **29.12.1999 IT MI992739**

(43) Date of publication of application:
**02.01.2002 Bulletin 2002/01**

(73) Proprietor: **ABB Service S.r.l
20124 Milano (IT)**

(72) Inventors:
• **MANARA, Angelo
I-20139 Milano (IT)**
• **DE BORTOLI, Eros
I-31041 Cornuda (IT)**

• **DI RIENZO, Luca
I-50132 Firenze (IT)**
• **PIAZZESI, Alice
CH-5408 Ennetbaden (CH)**

(74) Representative: **Giavarini, Francesco et al
ZANOLI & GIAVARINI S.r.l.
Viale Bianca Maria, 35
20122 Milano (IT)**

(56) References cited:
**US-A- 4 625 166**

• **PATENT ABSTRACTS OF JAPAN vol. 1996, no.
11, 29 November 1996 (1996-11-29) & JP 08
194016 A (FUJI ELECTRIC CO LTD), 30 July 1996
(1996-07-30)**

**Description**

The present invention relates to an improved current sensing device for low-voltage power circuit breakers.

Many examples of current sensing devices for monitoring and protecting low voltage power circuit breakers (therefore for voltage values approximately below 1 kV) are known in the state of the art. These current devices are based on different physical principals. A first example is represented by current sensing devices based on the thermoelectric effect. These current sensing devices generally use a bimetallic lamina, which is heated by the flow of the current to be measured and interrupts the current as soon as a certain temperature threshold is exceeded. These kinds of current sensing devices produce a threshold-type operation of the sensing system, which does not provide continuous monitoring of the current. This behavior is affected considerably by the ambient temperature: this fact leads to a maximum accuracy, which is approximately around the 20% of the nominal value of the current to be measured. Another example of current sensing devices is represented by devices, which are aimed at sensing the circulation of the magnetic field. Basically two main types of current sensing devices are based on this principle. A first type is represented by current sensing transformers that are widely used owing to its simple constructive characteristics and to its modest cost. However, current sensing transformers are capable of measuring only alternating currents. Furthermore, especially for high currents, current sensing transformers behave in a highly nonlinear manner and do not allow accurate measurements, in addition to being unable to operate for direct current. A second type is represented by current sensing arrangements comprising some flux-sensing means (typically Hall-effect devices) and a magnetic field concentrator. These current sensing devices are characterized by two main configurations, namely, "closed-loop configuration" and "open-loop configuration". According to the mentioned closed-loop configuration, the concentrator is made of ferromagnetic material provided with a narrow gap. The flux-sensing means are located in this gap. The signals coming from the sensing means are used to drive an amplifier, which supplies a secondary circuit, which is wound on the concentrator, so as to produce a flux that cancels out the flux of the primary current. In this manner, the secondary current is an image of the primary current. This kind of arrangement also works for direct currents but requires a power supply current, which is usually not available. Further, the cost of this sensing method is very high. According to the mentioned open-loop current configuration, the flux in the gap of the concentrator is measured and the measured values are put in relation with the values of the concatenated current by means of an appropriate constant. The open-loop configuration, as well as the closed loop configuration, has problems in terms of non-linearity in the sensing of high-intensity currents.

A further example of current sensing devices is represented by devices, which are aimed at performing a spot measurement of the magnetic field. Various kinds of current sensing devices can be used for this scope. Hall sensors, so-called flux-gate sensors, magneto-resistors and the like are the most widely considered. For example, the American Patent US 4 625 166 discloses a current sensing device in which a plurality of Hall probes perform a spot measurement of the magnetic field. The adoption of spot measurements of the magnetic field entails poor rejection of the influence of magnetic interference fields, i.e., fields generated by currents other than the one to be measured.

Further, current sensing devices of another kind adopt arrangements aimed at sensing the voltage drop on a resistive shunt. This kind of measurement requires galvanic contact with the conductors, in which the current to be measured resides, and, therefore, it does not meet the requirement of obtaining substantially "contact-less" measurements. Resistive shunts, which are usable for direct current as well, further generate too much heat and require the use of high-insulation transducers.

In practice, as a general statement, one can say that the known current sensing devices for low voltage power circuit breakers are affected by several and remarkable drawbacks that make quite difficult and expensive their application.

Therefore, the aim of the present invention is to provide a current sensing device for low-voltage power circuit breakers, which allows overcoming the mentioned drawbacks.

Within this scope, another object of the present invention is to provide a current sensing device for low-voltage power circuit breakers, which is characterized by a high level of rejection from disturbances generated by currents that are not to be measured, with a consequent higher measurement precision than conventional solutions.

Another object of the present invention is to provide a current sensing device, which can operate both with alternating current and with direct current.

Another object of the present invention is to provide a current sensing device, which is characterized by high linearity levels.

Another object of the present invention is to provide a current sensing device, which is characterized by a wide dynamic range of measurement.

Another object of the present invention is to provide a current sensing device, which is characterized by a broad frequency response.

Another object of the present invention is to provide a current sensing device, which is characterized by high levels of reliability and it is, relatively simple to manufacture and at competitive costs.

Thus, the present invention as defined by claim 1 provides a current sensing device for sensing the current of one or more current conductor elements in a low-voltage power circuit breaker.

Further characteristics and advantages of the current sensing device, according to the present invention, will become apparent from the description of preferred but not exclusive embodiments that are illustrated only by way of non-limitative example in the accompanying drawings, wherein:

Figure 1 is a schematic view of a generic current system to be measured by means of the current sensing device, according to the present invention;
Figure 2 is a block diagram of the current sensing device, according to the present invention;
Figure 3 is a schematic view of an embodiment of a current sensing device for measuring current by detecting the magnetic field generated by the currents to be measured; and
Figure 4 is a view of a second embodiment of the current sensing device, according to the present invention.

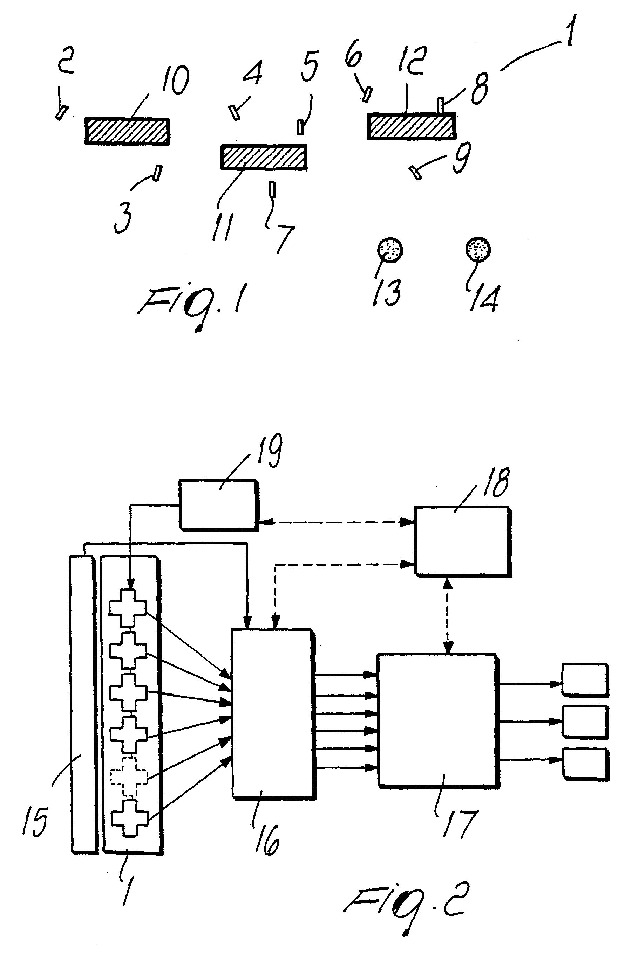

With reference to the above mentioned figures, the current sensing device, according to the present invention, is suitable for measuring direct and alternating currents. The current sensing device, according to the present invention, is aimed at sensing the current of one or more current conductor elements 10-12. The number of conductor elements is, obviously, not limited to the number shown in Figure 1. Further, the current conductor elements 10-12 preferably comprise the phase conductors of the low voltage power circuit breaker.

The figures also show two conductors 13 and 14, which constitute conductors not belonging to the selected current system and whose current measurement is assumed to be irrelevant. The position and number of these conductors is not restrictive and is only illustrated by way of example.

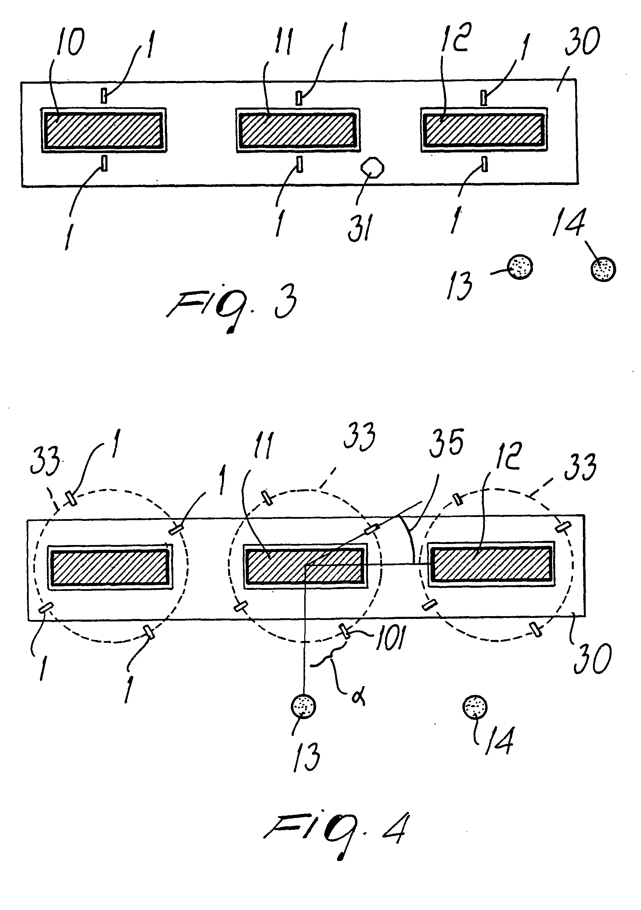

The current sensing device, according to the present invention, comprises a plurality of magnetic field sensors, arranged around one of the conductor elements 10-12. The magnetic field sensors are generally designated by the reference numeral 1 in Figure 2 and individually designated, by way of example, by the reference numerals 2, 3, 4, 5, 6, 7, 8 and 9 in Figure 1. The magnetic field sensors 1 perform a spot measurement of the magnetic field and, therefore, generate sensing signals indicative of the value of the current flowing through one of the current conductor elements (e.g. the conductor element 10).

The magnetic field sensors 1 are oriented and positioned around the conductor element 10 according to a predefined arrangement, which is aimed at optimizing the precision of the measurements performed by the magnetic field sensors 1.

The sensing signals generated by the magnetic field sensors 1 are processed by conditioning means 16 (see Figure 2), which perform operations for compensating magnitudes and characteristics of the devices used as magnetic field sensors (for example offset, non-linearity, et cetera) or with respect to external magnitudes, such as, for example, the operating temperature. The conditioning means 16 can use measurements of the mentioned external magnitudes performed proximate to the magnetic field sensors and generally designated by the reference numeral 15. The output signals of the signal conditioning means 16 are sent to the signal processing means 17. Alternatively, if the conditioning means 16 are not present, the processing means 17 can directly process the sensing signals of the sensors 1. The signal processing means 17 perform the operations related to the predefined matrix relations. Control means 18 are provided in order to manage the correct execution of the measurement on the part of the magnetic field sensors 1 used for detection. Finally, power supply means 19 supply the plurality of magnetic field sensors 1 and the control means 18. The control means 18 communicate with the signal conditioning means 16 and with the signal processing means 17. The signal conditioning means 16, the signal processing means 17 and the control means 18 can be physically provided by means of analog or digital electronic circuits and devices, which are known in the art.

As mentioned the signal processing means 17 perform the operations related to the predefined matrix relations. Particularly, the signal processing means 17 means are suitable to solve a predefined matrix system in which the values of the current are obtained on the basis of:

- a predefined vector, which comprises the values of the magnetic field measured by the magnetic field sensors 1; and
- a function matrix, which depends on a predefined interaction matrix comprising the values related to the position and the orientation of the magnetic field sensors and/or other current calibration values.

In fact, let S be the vector of the sensing signals supplied by the magnetic field sensors 1 and let I be the vector of the currents that have to be measured. It is possible to write the relation:

$$S = A \times I \tag{1}$$

in which A is the interaction matrix, which can be calculated on the basis position and orientation of the magnetic field sensors and/or depending on the geometric dimensions and physical characteristics of the system or measured (for example if a system of known currents is set).

If the interaction matrix A is known, the unknown currents I can be obtained by writing the relation:

$$I = Q \times S \qquad\qquad (2)$$

in which Q is a function matrix depending on the interaction matrix A, which can be obtained by known algebraic and/or statistical methods of the linear or non-linear type (for example least-squares method, constrained least-squares, and the like).

The predefined matrix system, which is expressed by the relation (2), can be advantageously solved in the domain of frequency.

In fact, adopting for example a Discrete Fourier Transform of the vectors I and

S and taking into consideration some known methods, proposed in the estimation theory, that relate to the statistical properties of signal harmonic components, the function matrix Q can be easily calculated.

As mentioned, the magnetic field sensors 1 are then used to detect the magnetic field generated by the currents to be measured. The current sensing device, according to the present invention, is substantially independent, for its operation, of the type of magnetic field sensors 1 that can be adopted. The type of magnetic field sensors may only affect the definition of the functions performed by the signal conditioning means 16 and/or by the control means 15. The magnetic field sensor provided may be any suitable type of sensor, such as for example a Hall-effect sensor. This type of sensor is particularly advantageous owing to its low cost and wide frequency band, which allows performing both AC and DC current measurements.

Figure 3 is a view of a first embodiment of the arrangement of magnetic field sensors 1. The magnetic field sensors 1 can be arranged around conductor elements 10-12 having a rectangular cross-section, which are likewise similar to the conductor elements of Figure 1 and are arranged at the middle axis of the conductor elements 10-12. The magnetic field sensors 1 can be arranged on an appropriate supporting element 30, which is made of preferably insulating material and has a shape, which can vary according to the requirements. If necessary, the supporting element 30 can be used to accommodate magnetic field sensors, for example a sensor 31, which measure external magnitudes, such as for example the temperature. Further, the supporting element 30 can be used to accommodate part of the control electronics of the system, for example the signal conditioning means 16 and the signal processing means 17.

In Figure 3, two magnetic field sensors are arranged along a middle axis of the rectangular cross-section of the switch. In general, two magnetic field sensors can be arranged in a substantially vertical direction with respect to one of the longer sides of the rectangular cross-section.

The arrangement of the magnetic field sensors 1 shown in Figure 3 is particularly advantageous, since it allows performing the measurement by using magnetic field sensors 1, which are arranged only around the conductor elements 10-12. The solution, i.e., the detected measurement, is exact if the interfering currents, which pass through the conductors 13 and 14 are zero. Otherwise, the solution becomes an approximation, which is increasingly accurate depending on how appropriately the magnetic field sensors 1 are arranged around the conductor elements 10-12.

In an extreme case, if one can assume the position of the conductors 13 and 14 to be invariant over time, it is possible to experimentally determine, once and for all, their interaction like the other currents. For example the calibration can be performed after the installation of the current sensing device, thus providing an exact solution for all currents.

With reference now to Figure 4, a second embodiment of the arrangement of the magnetic field sensors 1 around the conductor elements 10-12 is illustrated.

In this second embodiment, the magnetic field sensors 1, related to each one of the conductor elements 10-12, are arranged along a closed line, which surrounds each of the conductor elements 10-12. Conveniently, the closed line can be a circle or an ellipse, which is concentric with respect to the conductor elements 10-12.

This allows to considerably increasing the rejection to external noise. In fact, by virtue of appropriate arrangements of the magnetic field sensors 1 along the closed line, designated by the reference numeral 33, and an appropriate signal processing performed by the processing means 17, the result is largely independent, and in some particular cases absolutely independent, of any other currents present proximate to the magnetic field sensors 1. For example, it is possible to determine an arrangement of the magnetic field sensors 1, which renders the result of the measurement of the magnetic field sensors absolutely insensitive to the current that flows in the adjacent conductor elements (one of the conductor elements 10-12 adjacent to one of said conductor elements 10-12) and relatively insensitive to the currents in the conductors 13 and 14. It is furthermore possible to demonstrate that a simple arithmetic average of the sensing signals the magnetic field sensors 1 (performed in the signal processing means 17) provides an accurate measurement of the current that flows through the conductor element 10-12 surrounded by the magnetic field sensors 1.

In order to better illustrate these concepts, Figure 4 shows a circular arrangement of the magnetic field sensors 1, which are all tilted at an angle 35 with respect to a longitudinal axis which passes through the center of the conductor elements, which have a rectangular cross-section. The angle 35 depends on the dimensions of the cross-section of the conductor elements 10-12. Therefore, in order to optimize rejection of noise generated by currents flowing in adjacent conductor elements, it is important to determine an appropriate arrangement according to the shape and dimensions of the conductor element elements 10-12, characterized by the arrangement around the conductor element and by the orientation and number of the magnetic field sensors. This arrangement is determined by virtue of mixed, algebraic and numeric methods.

For example, for a circular arrangement of the sensors 1, as shown in Figure 4, it can be demonstrated that the relative error caused by currents (flowing in the conductors 13 and 14), which are external to the circumference 33, on which the magnetic field sensors are arranged, is a function of the angle formed by a plane, which contains the circumference with the longitudinal axis of a conductor element (direction of flow of the current) 101.

Let $\alpha$ be said angle; the error is given by the following equation:

$$E = I \cdot (d/D)^{N \cdot \cos(N \cdot (\alpha))} \tag{3}$$

where I is the intensity of the current not to be measured, d is the radius of the circumference 33 on which the magnetic field sensors 1 are arranged, N is the number of magnetic field sensors 1, and D is the distance of the current I (which is not to be measured) from the center of the circumference 33, while $\alpha$ is the above cited angle.

The current sensing device, according to the present invention, furthermore has the particularity that it does not have ferromagnetic cores, and this entails advantages in terms of linearity of the measurement, low manufacturing costs, reduction of mass and better electrical insulation.

In practice, it has been found that the current sensing device, according to the present invention, fully achieves the intended aim and objects. In fact, it allows sensing the intensity of the current that flows in a current conductor element, with high rejection of noise originating for example from currents flowing in adjacent conductor elements.

The current sensing device, according to the present invention, is particularly suitable for the measurement of current in low-voltage industrial switches.

If the switch is provided with an electronic relay, the use of the current sensing device, according to the present invention, would have no additional cost as regards the conditioning and signal processing electronics, since this electronics is already present in the mentioned electronic relay.

The current sensing device, according to the present invention thus conceived is susceptible of numerous modifications and variations, all of which are within the scope of the inventive concept defined by the claims.

## Claims

1. A current sensing device for sensing the current of one or more current conductor elements (10,11,12) of a low voltage power circuit breaker, comprising:

    - a plurality of magnetic field sensors (1,2,3,4,5,6,7,8,9) arranged around at least one of said conductor elements (10,11,12) so as to perform a spot measurement of the magnetic field and generate sensing signals indicative of the value of the current flowing through said current conductor element (10,11,12), said magnetic field sensors (1,2,3,4,5,6,7,8,9) being positioned and oriented around said conductor element (10,11,12) according to a predefined arrangement;
    - signal processing means (17) suitable to receive and process said sensing signals;

    **characterized in that** said signal processing means (17) is adapted to solve a predefined matrix system in which a vector comprising the values of the current flowing through said current conductor element (10,11,12) is obtained on the basis of:

    - a predefined vector comprising the values of the magnetic field measured by said magnetic field sensors (1,2,3,4,5,6,7,8,9); and
    - a function matrix, said function matrix being dependent on a predefined interaction matrix comprising the values related to the position and the orientation of said magnetic field sensors (1,2,3,4,5,6,7,8,9) and/or current calibration values.

2. A current sensing device according to claim 1, **characterized in that** it further comprises signal conditioning means (16) interposed between said plurality of magnetic field sensors (1,2,3,4,5,6,7,8,9) and said signal processing means (17), said signal conditioning means (17) being suitable to perform compensation operations on said sensing signals.

3. A current sensing device according to claim 2, **characterized in that** it comprises control means (18) for controlling said conditioning means (16) and said signal processing means (17).

4. A current sensing device according to one or more of claims from 1 to 3, **characterized in that** said predefined matrix system is solved in the domain of frequency.

5. A current sensing device according to one or more of the claims from 1 to 4, **characterized in that** said at least one conductor element (10,11,12) has a rectangular cross-section.

6. A current sensing device according to claim 5, **characterized in that** said plurality of magnetic field sensors (1,2,3,4,5,6,7,8,9) comprises two sensors arranged in a substantially vertical direction with respect to one of the longer sides of said rectangular cross-section.

7. A current sensing device according to claim 5 or 6, **characterized in that** said plurality of magnetic sensors (1,2,3,4,5,6,7,8,9) comprises two magnetic field sensors arranged along a middle axis of said rectangular cross-section.

8. A current sensing device according to claim 5, **characterized in that** said plurality of magnetic field sensors (1,2,3,4,5,6,7,8,9) are arranged along a closed line surrounding said current conductor element.

9. A current sensing device according to claim 8, **characterized in that** said closed line is a circumference.

10. A current sensing device according to claim 8, **characterized in that** said closed line is a ellipse.

11. A current sensing device according to claims 8 or 9, **characterized in that** said plurality of magnetic field sensors (1,2,3,4,5,6,7,8,9) is arranged on a circumference, which lies on a plane that forms a preset angle with respect to the longitudinal axis of said conductor element (10,11,12).

12. A current sensing device according to claim 11, **characterized in that** said angle depends on the dimension and/or cross-section of said current conductor element and/or on the number of magnetic field sensors, so as to avoid electromagnetic interference effects.

13. A current sensing device according to one or more of the claims from 1 to 12, **characterized in that** said plurality of magnetic field sensors (1,2,3,4,5,6,7,8,9) is arranged on a supporting element (30).

14. A current sensing device according to claim 13, **characterized in that** said supporting element (30) furthermore supports said signal conditioning means (16) and/or said signal processing means (17) and/or said control means (18).

15. A current sensing device according to one or more of the claims from 1 to 14, **characterized in that** said one or more current conductor elements (10,11,12) comprise the phase conductors of said low-voltage power circuit breaker.

16. A low-voltage power circuit breaker, **characterized in that** it comprises at least a current sensing device according to one or more of the claims from 1 to 15.

17. A low-voltage power circuit breaker, according to claim 16, **characterized in that** it is provided with an electronic relay.

**Patentansprüche**

1. Strommessvorrichtung zum Messen des Stroms von einem oder mehreren Stromleiterelementen (10, 11, 12) eines Niederspannungs-Leistungsschalters, umfassend:

- eine Vielzahl von Magnetfeldsensoren (1, 2, 3, 4, 5, 6, 7, 8, 9), die um mindestens eines der Leiterelemente (10, 11, 12) herum angeordnet sind, um eine Punktmessung des Magnetfelds durchzuführen und Messsignale zu erzeugen, die den Wert des durch die Stromleiterelemente (10, 11, 12) fließenden Stromes anzeigen, wobei die Magnetfeldsensoren (1, 2, 3, 4, 5, 6, 7, 8, 9) um das Leiterelement (10, 11, 12) entsprechend einer vorbestimmten Anordnung herumpositioniert und -orientiert sind;
- eine Signalverarbeitungsvorrichtung (17), die geeignet ist, die Messsignale zu empfangen und zu verarbeiten;
- **dadurch gekennzeichnet, dass** die Signalverarbeitungsvorrichtung (17) geeignet ist, ein vorbestimmtes Matrixsystem zu lösen, in welchem ein Vektor mit den Werten des durch die Stromleiterelemente (10, 11, 12) fließenden Stroms auf folgender Grundlage erhalten wird:

- einem vorbestimmten Vektor mit den Werten des von den Magnetfeldsensoren (1, 2, 3, 4, 5, 6, 7, 8, 9) gemessenen Magnetfeldes; und
- einer Funktionsmatrix, wobei die Funktionsmatrix von einer vorbestimmten Wechselwirkungsmatrix abhängig ist, die die mit der Position und der Orientierung der Magnetfeldsensoren (1, 2, 3, 4, 5, 6, 7, 8, 9) zusammenhängenden Werte und/oder Stromkalibrierungswerte umfasst.

2. Strommessvorrichtung nach Anspruch 1, **dadurch gekennzeichnet, dass** sie des Weiteren eine Signalbearbeitungsvorrichtung (16) umfasst, die sich zwischen der Vielzahl der Magnetfeldsensoren (1, 2, 3, 4, 5, 6, 7, 8, 9) und der Signalverarbeitungsvorrichtung (17) befindet, wobei die Signalbearbeitungsvorrichtung (16) geeignet ist, Kompensierungsoperationen an den Messsignalen durchzuführen.

3. Strommessvorrichtung nach Anspruch 2, **dadurch gekennzeichnet, dass** sie eine Steuervorrichtung (18) zum Steuern der Bearbeitungsvorrichtung (16) und der Signalverarbeitungsvorrichtung (17) umfasst.

4. Strommessvorrichtung nach einem oder mehreren der Ansprüche 1 bis 3, **dadurch gekennzeichnet, dass** das vorbestimmte Matrixsystem in der Frequenzebene gelöst wird.

5. Strommessvorrichtung nach einem oder mehreren der Ansprüche 1 bis 4, **dadurch gekennzeichnet, dass** mindestens ein Leiterelement (10, 11, 12) einen rechteckigen Querschnitt aufweist.

6. Strommessvorrichtung nach Anspruch 5, **dadurch gekennzeichnet, dass** die Vielzahl der Magnetfeldsensoren (1, 2, 3, 4, 5, 6, 7, 8, 9) zwei Sensoren umfasst, die im Wesentlichen in einer vertikalen Richtung in Bezug auf eine der längeren Seiten des rechteckigen Querschnitts angeordnet sind.

7. Strommessvorrichtung nach Anspruch 5 oder 6, **dadurch gekennzeichnet, dass** die Vielzahl von Magnetfeldsensoren (1, 2, 3, 4, 5, 6, 7, 8, 9) zwei Magnetfeldsensoren umfasst, die entlang einer Mittelachse des rechteckigen Querschnitts angeordnet sind.

8. Strommessvorrichtung nach Anspruch 5, **dadurch gekennzeichnet, dass** die Vielzahl von Magnetfeldsensoren (1, 2, 3, 4, 5, 6, 7, 8, 9) entlang einer geschlossenen Linie angeordnet sind, die die Stromleiterelemente umgibt.

9. Strommessvorrichtung nach Anspruch 5, **dadurch gekennzeichnet, dass** die geschlossenen Linie eine Kreislinie ist.

10. Strommessvorrichtung nach Anspruch 8, **dadurch gekennzeichnet, dass** die geschlossene Linie eine Ellipse ist.

11. Strommessvorrichtung nach Anspruch 8 oder 9, **dadurch gekennzeichnet, dass** die Vielzahl von Magnetfeldsensoren (1, 2, 3, 4, 5, 6, 7, 8, 9) auf einer Kreislinie angeordnet ist, die auf einer Ebene liegt, die einen vorbestimmten Winkel in Bezug auf die Längsachse des Leiterelements (10, 11, 12) ausbildet.

12. Strommessvorrichtung nach Anspruch 11, **dadurch gekennzeichnet, dass** der Winkel von den Abmessungen und/oder dem Querschnitt des Stromleiterelements und/oder von der Anzahl der Magnetfeldsensoren abhängt, um elektromagnetische Störeffekte zu vermeiden.

13. Strommessvorrichtung nach einem oder mehreren der Ansprüche von 1 bis 12, **dadurch gekennzeichnet, dass** die Vielzahl von Magnetfeldsensoren (1, 2, 3, 4, 5, 6, 7, 8, 9) auf einem Stützelement (30) angeordnet ist.

14. Strommessvorrichtung nach Anspruch 13, **dadurch gekennzeichnet, dass** das Stützelement (30) des Weiteren die Signalbearbeitungsvorrichtung (16) und/oder die Signalverarbeitungsvorrichtung (17) und/oder die Steuervorrichtung (18) trägt.

**15.** Strommessvorrichtung nach einem oder mehreren der Ansprüche von 1 bis 12, **dadurch gekennzeichnet, dass** ein oder mehrere Stromleiterelemente (10, 11, 12) die Phasenleiter eines Niederspannungs-Leistungsschalter umfassen.

**16.** Niederspannungs-Leistungsschalter, **dadurch gekennzeichnet, dass** er mindestens eine Strommessvorrichtung nach einem oder mehreren der Ansprüche 1 bis 15 umfasst.

**17.** Niederspannungs-Leistungsschalter nach Anspruch 16, **dadurch gekennzeichnet, dass** er mit einem elektronischen Relais versehen ist.

**Revendications**

**1.** Un détecteur de courant pour détecter le courant d'un ou plusieurs éléments conducteurs de courant (10, 11, 12), d'un disjoncteur de puissance basse-tension, comprenant:

- une pluralité de capteurs de champ magnétique (1, 2, 3, 4, 5, 6, 7, 8, 9) agencés autour d'au moins l'un desdits éléments conducteurs (10, 11, 12), pour effectuer une mesure ponctuelle du champ magnétique et générer des signaux de détection indicatifs de la valeur du courant passant par ledit élément conducteur de courant (10, 11, 12), lesdits capteurs de champ magnétique (1, 2, 3, 4, 5, 6, 7, 8, 9) étant positionnés et orientés autour dudit élément conducteur (10, 11, 12), selon un agencement prédéfmi;
- des moyens de traitement de signal (17), convenant pour recevoir et traiter lesdits signaux de détection;

**caractérisé en ce que** lesdits moyens de traitement de signal (17) sont adaptés pour résoudre un système matriciel prédéfini, dans lequel un vecteur comprenant les valeurs du courant passant par ledit élément conducteur de courant (10, 11, 12) est obtenu sur la base de:

- un vecteur prédéfini comprenant les valeurs de champ magnétique mesurées par lesdits capteurs de champ magnétique (1, 2, 3, 4, 5, 6, 7, 8, 9); et
- une matrice fonctionnelle, ladite matrice fonctionnelle dépendant d'une matrice d'interaction prédéfinie, comprenant les valeurs liées à la position et à l'orientation desdits capteurs de champ magnétique (1, 2, 3, 4, 5, 6, 7, 8, 9) et/ou des valeurs d'étalonnage de courant.

**2.** Un détecteur de courant selon la revendication 1, **caractérisé en ce qu'**il comprend en outre des moyens de conditionnement de signaux (16), interposés entre ladite pluralité de capteurs de champ magnétique (1, 2, 3, 4, 5, 6, 7, 8, 9) et lesdits moyens de traitement de signaux (17), lesdits moyens de conditionnement de signaux (17) convenant pour accomplir des opérations de compensation sur lesdits signaux de détection.

**3.** Un détecteur de courant selon la revendication 2, **caractérisé en ce qu'**il comprend des moyens de commande (18) pour commander lesdits moyens de conditionnement (16) et lesdits moyens de traitement de signaux (17).

**4.** Un détecteur de courant selon l'une ou plusieurs des revendications 1 à 3, **caractérisé en ce que** ledit système matriciel prédéfmi est résolu dans le domaine des fréquences.

**5.** Un détecteur de courant selon l'une ou plusieurs des revendications 1 à 4, **caractérisé en ce que** ledit au moins un élément conducteur (10, 11, 12) présente une section transversale rectangulaire.

**6.** Un détecteur de courant selon la revendication 5, **caractérisé en ce que** ladite pluralité de capteurs de champ magnétique (1, 2, 3, 4, 5, 6, 7, 8, 9) comprend deux capteurs, agencés en une direction sensiblement verticale par rapport à l'un des côtés long de ladite section transversale rectangulaire.

**7.** Un détecteur de courant selon la revendication 5 ou 6, **caractérisé en ce que** ladite pluralité de capteurs de champ magnétique (1, 2, 3, 4, 5, 6, 7, 8, 9) comprend deux capteurs de champ magnétique, agencés le long d'un axe médian de ladite section transversale rectangulaire.

**8.** Un détecteur de courant selon la revendication 5, **caractérisé en ce que** ladite pluralité de capteurs de champ magnétique (1, 2, 3, 4, 5, 6, 7, 8, 9) sont agencés le long d'une ligne fermée, entourant ledit élément conducteur de courant.

**9.** Un détecteur de courant selon la revendication 8, **caractérisé en ce que** ladite ligne fermée est une circonférence.

**10.** Un détecteur de courant selon la revendication 8, **caractérisé en ce que** ladite ligne fermée est une ellipse.

**11.** Un détecteur de courant selon la revendication 8 ou 9, **caractérisé en ce que** ladite pluralité de capteurs de champ magnétique (1, 2, 3, 4, 5, 6, 7, 8, 9) est agencée sur une circonférence située dans un plan, formant un angle préétabli par rapport à l'axe longitudinal dudit élément conducteur (10, 11, 12).

**12.** Un détecteur de courant selon la revendication 11, **caractérisé en ce que** ledit angle dépend de la dimension et/ou de la section transversale dudit élément conducteur de courant et/ou du nombre de capteurs de champ magnétique pour éviter des effets d'interférence électromagnétique.

**13.** Un détecteur de courant selon une ou plusieurs des revendications 1 à 12, **caractérisé en ce que** ladite pluralité de capteurs de champ magnétique (1, 2, 3, 4, 5, 6, 7, 8, 9) est agencée sur un élément support (30).

**14.** Un détecteur de courant selon la revendication 13, **caractérisé en ce que** ledit élément support (30) supporte en outre lesdits moyens de conditionnement de signaux (16) et/ou lesdits moyens de traitement de signaux (17) et/ou lesdits moyens de commande (18).

**15.** Un détecteur de courant selon l'une ou plusieurs des revendications 1 à 14, **caractérisé en ce que** ledit un ou plusieurs éléments conducteur de courant (10, 11, 12) comprend les conducteurs de phase dudit disjoncteur de puissance basse-tension.

**16.** Un disjoncteur de puissance basse-tension, **caractérisé en ce qu'**il comprend au moins un détecteur de courant selon l'une ou plusieurs des revendications 1 à 15.

**17.** Un disjoncteur de puissance basse-tension selon la revendication 16, **caractérisé en ce qu'**il est muni d'un relais électronique.

Fig. 1

Fig. 2

Fig. 3

Fig. 4